# EUROPEAN PATENT SPECIFICATION

(11) **EP 2 652 583 B1**
(45) Date of publication and mention of the grant of the patent: **18.03.2020**
(21) Application number: 12734591.6
(22) Date of filing: 10.01.2012
(51) Int. Cl.: G06F 3/041

(54) **TOUCH PANEL, METHOD FOR MANUFACTURING THE SAME, AND LIQUID CRYSTAL DISPLAY DEVICE INCLUDING THE TOUCH PANEL**
BERÜHRUNGSBILDSCHIRM, HERSTELLUNGSVERFAHREN DAFÜR UND FLÜSSIGKRISTALLANZEIGEVORRICHTUNG MIT DEM BERÜHRUNGSBILDSCHIRM
ÉCRAN TACTILE, SON PROCÉDÉ DE FABRICATION ET DISPOSITIF D'AFFICHAGE À CRISTAUX LIQUIDES COMPRENANT L'ÉCRAN TACTILE

(30) Priority: 13.01.2011 KR 20110003739
(43) Date of publication of application: 23.10.2013
(73) Proprietor: LG Innotek Co., Ltd., Seoul, 04637 (KR)
(72) Inventor: YOU, Young Sun, Seoul 100-714 (KR); LEE, Yong Jin, Seoul 100-714 (KR); CHAI, Kyoung Hoon, Seoul 100-714 (KR); LEE, Dong Youl, Seoul 100-714 (KR); NOH, Young Jin, Seoul 100-714 (KR); LEE, Sun Young, Seoul 100-714 (KR)
(74) Representative: Novagraaf Technologies
(86) International application number: PCT/KR2012/000231
(87) International publication number: WO 2012/096492

(56) References cited:
- JP-A- 2002 229 737
- JP-A- 2004 234 386
- JP-A- 2005 032 989
- JP-A- 2008 065 748
- JP-A- 2008 077 332
- US-A1- 2009 218 651
- US-A1- 2009 219 258
- US-A1- 2010 265 193

## Description

### Technical Field

The disclosure relates to a touch panel, a method for manufacturing the same, and a liquid crystal display device including the touch panel.

### Background Art

Recently, a touch panel, which performs an input function through the touch of an image displayed on a display device by an input device such as a stylus pen or a hand, has been applied to various electronic appliances.

The touch panel may be mainly classified into a resistive touch panel and a capacitive touch panel. In the resistive touch panel, glass is shorted with an electrode due to the pressure of the input device so that a touch point is detected. In the capacitive touch panel, the variation in capacitance between electrodes is detected when a finger of the user is touched on the capacitive touch panel, so that the touch point is detected.

In this case, in order to pattern the electrode, various manufacturing processes such as a process of forming a mask and a process of depositing electrode materials are required. Accordingly, the manufacturing process may be complicated, and the manufacturing cost may be increased.

In general, the electrode includes ITO (indium tin oxide). When the electrode is manufactured by depositing the ITO, the thin deposition thickness is formed, so that high resistance is represented in the electrode.

Therefore, a touch panel including the electrode material substituting for the ITO, and an electrode formed by using the electrode material through a simple process is required, respectively.

### Disclosure of Invention

### Technical Problem

The embodiment relates to a touch panel and a method for manufacturing the same in which the manufacturing process can be simple, and the process cost can be reduced. State of the Art.

Document US 2009 219258 discloses a touch panel including a substrate including at least one concave part, and a transparent electrode formed in the concave part to detect a position.

### Advantageous Effects of Invention

As described above, in the touch panel according to the invention and the method for manufacturing the same, since the concave part is formed in the substrate, and the electrode is formed in the concave part, the manufacturing process is simplified. Accordingly, the manufacturing process and the manufacturing cost can be reduced. In the invention when the transparent electrode of the 2-layer touch panel is formed, since an additional film or an additional substrate can be omitted, the stack structure of the touch panel can be simplified. Accordingly, the transmittance can be improved, and the thickness can be reduced. When the electrode is formed in the concave part, the electrode may be formed by using an electrode material substituting for conventional ITO.

### Brief Description of Drawings

FIG. 1 is a sectional view showing a touch panel.
FIG. 2 is a sectional view showing a touch panel.
FIG. 3 is a sectional view showing a touch panel according to the invention.
FIGS. 4 to 9 are sectional views showing a method for manufacturing the touch panel of FIG. 9; and
FIG. 10 is a sectional view schematically showing a liquid crystal display device.

### Mode for the Invention

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" over the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, embodiments of the present invention will be described in detail with respect to accompanying drawings.

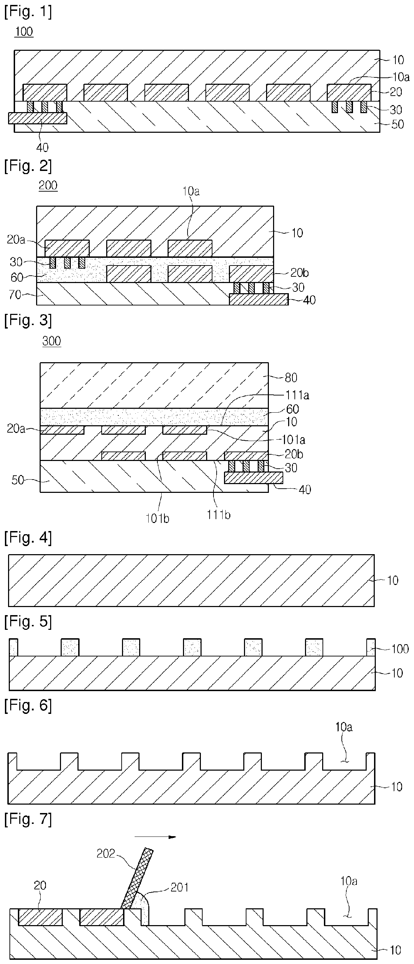

Hereinafter, a touch panel 100 will be described with reference to FIG. 1. FIG. 1 is a sectional view showing the touch panel.

Referring to FIG. 1, in the touch panel 100, a transparent electrode 20 may be formed on a substrate 10 to detect an input device. In addition, interconnections 30 connected to the transparent electrode 20 and a printed circuit board 40 capable of connecting the interconnections 30 to an external circuit (not shown) may be provided.

If an input device such as a finger is touched on the touch panel, the difference in capacitance is made on a touched portion by the input device, and the touched portion representing the difference in the capacitance may be detected as a touch point.

Hereinafter, the touch panel 100 will be described in more detail.

After the transparent electrode 20 is formed on the substrate 10 having a concave part 10a, the interconnection 30 may be connected to the transparent electrode 20, and the printed circuit board 40 may be connected to the interconnection 30. In addition, a scattering prevention film 50 may be formed to cover the transparent electrode 20, the interconnection 30, and the printed circuit board 40.

The substrate 10 may include various materials to support the transparent electrode 20 and the interconnection 30. For instance, the substrate 10 may include a glass substrate.

Thereafter, at least one concave part 10a may be formed on the substrate 10. The depth of the concave part 10a may be formed to 50% or less of the thickness of the substrate 10. If the depth of the concave part 10a exceeds 50% of the thickness of the substrate 10, the physical strength of the substrate 10 may be weakened due to the concave part 10a formed in the substrate 10.

The shape of the concave part 10a may be the same as that of the transparent electrode 20 to be formed on the substrate 10. In other words, the shape of the concave part 10a is the very same as the shape of the transparent electrode 20.

Thereafter, the transparent electrode 20 is formed in the concave part 10a of the substrate 10. The transparent electrode 20 may include a printable paste material. For example, the transparent electrode 20 may include a carbon nano-tube (CNT), a conductive polymer, and an Ag nano-tube. The materials may substitute for ITO (indium tin oxide). The materials have an advantage in terms of a price, and may be formed through a simple process.

In addition, since the transparent electrode 20 is formed in the concave part 10a of the substrate 10, the transparent electrode 20 may be prevented from being corroded or damaged due to external conditions.

Thereafter, the interconnection 30 connected to the transparent electrode 20 and the printed circuit board 40 connected to the interconnection 30 are formed. The interconnection 30 may include metal representing superior electrical conductivity. The printed circuit board 40 may include printed circuit boards having various structures. For example, the printed circuit board may include an FPCB (flexible printed circuit board).

The scattering prevention film 50 may cover the transparent electrode 20, the interconnection 30, and the printed circuit board 40. The scattering prevention film 50 prevents fragments from being scattered when the touch panel 100 is broken due to the impact. The scattering prevention film 50 may include various materials and have various structures.

Hereinafter, a touch panel according will be described in detail with reference to FIG. 2. In the following description, the details of structures and components the same as those of figure 1 or extremely similar will be omitted except for only structures and components making the difference from those of the first embodiment for the purpose of clear and simple explanation.

FIG. 2 is a sectional view showing a touch panel 200.

Transparent electrodes 20a and 20b of the touch panel 200 a first transparent electrode 20a extending in one direction and a second transparent electrode 20b formed in a direction to cross the first transparent electrode 20a. In this case, the first transparent electrode 20a may be formed in the concave part 10a of the substrate 10, and the second transparent electrode 20b may be formed on a second substrate 70. The second substrate 70 may include a PET (poly (ethylene terephthalate) film or glass.

When the transparent electrode of the 2-layer touch panel is formed, since the first transparent electrode 20a is not formed on an additional panel, but directly formed in the concave part 10a of the substrate 10, the stack structure of the touch panel can be simplified. Accordingly, the transmittance of the touch panel can be improved, and the thickness of the touch panel can be reduced.

In addition, the first and second transparent electrodes 20a and 20b are provided on different layers, so that touch is more sensitively detected. Accordingly, a touch operation can be more exactly performed. In addition, a multi-touch panel, which has been spotlighted recently and can perform a multi-sensing function, can be provided.

Although not shown, in order to prevent the first and second transparent electrodes 20a and 20b from being electrically shorted with each other, an insulating layer (not shown) may be additionally provided between the first and second transparent electrodes 20a and 20b.

An OCA (optically clear adhesive) 60 is provided between the first and second transparent electrodes 20 and 20b, so that the substrate 10 may adhere to the second substrate 70. In addition, the OCA 60 may insulate the first transparent electrode 20a from the second transparent electrode 20b.

Hereinafter, the touch panel according to the invention will be described in detail with reference to FIG. 3.

FIG. 3 is a sectional view showing the touch panel according to the invention.

In the touch panel 300 according to the third embodiment, the first and second transparent electrodes 20a and 20b are provided on opposite surfaces of the substrate 10. In detail, the substrate 10 includes a top surface 111a making contact with an input device and a bottom surface 111b opposite to the top surface 111a, and includes a first concave part 101a of the top surface 111a and a second concave part 101b of the bottom surface 111b. In this case, the total depth of the first and second concave parts 101a and 101b is formed 50% or less of the thickness of the substrate 10.

Thereafter, the first transparent electrode 20a may be formed in the first concave part 101a, and the second transparent electrode 20b may be formed in the second concave part 101b. The touch panel 300 may include a protective glass layer 80 in order to protect the first transparent electrode 20a formed on the top surface 111a of the substrate 10. The protective glass layer 80 includes a hard coating layer so that the protective glass layer 80 is prevented from being scratched.

Hereinafter, a method for manufacturing the touch panel according to the embodiment will be described in detail with reference to FIGS. 4 to 9. In the following description, the details of structures and components the same as or extremely similar to those described above will be omitted except for only structures and components making the difference from those described above for the purpose of clear and simple explanation.

FIGS. 4 to 9 are sectional views showing the method for manufacturing the touch panel.

As shown in FIG. 4, the substrate 10 applicable to the touch panel is prepared.

Thereafter, as shown in FIGS. 5 and 6, after forming a mask 100 on the substrate 10 except for an electrode part, a portion of the substrate 10 without the mask 100 is etched to form the concave part 10a. The depth of the concave part 10a is formed to 50% or less of the thickness of the substrate 10 through the above etching process.

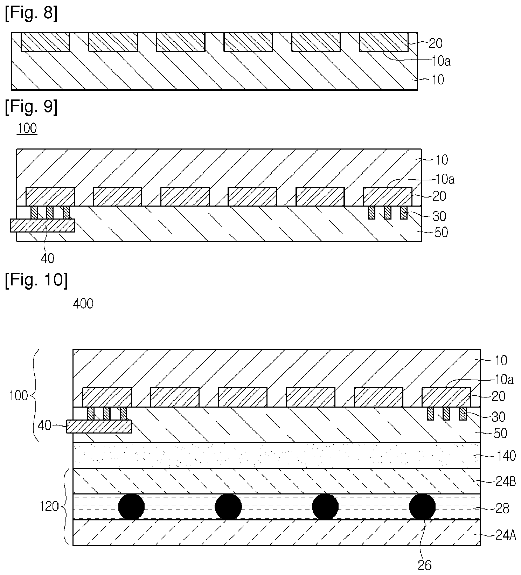

Thereafter, as shown in FIGS. 7 and 8, the electrode 20 is formed through the printing process. In detail, the concave part 10a may be filled with an electrode material 201 by using a doctor blade 202. In other words, the electrode material 201 is filled in the concave part 10a while moving the blade 202 in an arrow direction shown in FIG. 7 in the state that the doctor blade 202 makes contact with the substrate 10. Therefore, the electrode material 201 may include printable paste material instead of conventional ITO. For example, the electrode material 201 may include a carbon nano-tube (CNT), a conductive polymer, and an Ag nano-wire ink.

Conventionally, when the electrode is formed by using the ITO, an evaporation scheme employing a mask is performed to form an electrode pattern. However, according to the present embodiment, since the transparent electrode 20 is formed in the concave part 10a of the substrate 10, the vacuum deposition process may be omitted. In addition, since the transparent electrode 20 is formed through the simple printing process, the manufacturing cost can be reduced.

After the printing process, the process of sintering the transparent electrode 20 formed in the concave part 10a may be formed.

Hereinafter, as shown in FIG. 9, the interconnection 30, the printed circuit board 40, and the scattering prevention film 50 are additionally formed on the substrate 10, so that the touch panel can be manufactured.

Hereinafter, a liquid crystal display including a touch panel will be described with reference to FIG. 10. FIG. 10 is a sectional view schematically showing the liquid crystal display.

A liquid crystal display 400 according to the present embodiment may include a liquid crystal panel 120 equipped with the above-described touch panel 100. The touch panel 100 may receive external information from the screen of the liquid crystal panel 120, and may be stacked on the surface of the liquid crystal panel 120. In other words, the touch panel 100 may be bonded to the liquid crystal panel 120 by using an adhesive 140. For example, the adhesive 140 may include an OCA.

The liquid crystal panel 120 serves as a display section of the liquid crystal display device. The liquid crystal panel 120 displays an image by adjusting light transmittance of liquid cells injected into the two pieces of glass substrates. The liquid crystal cells adjust the quantity of light transmitted in response to a video signal, that is, a corresponding pixel signal.

The liquid crystal panel 120 has a liquid crystal material 28 and ball spacers 26 injected between lower and upper glass substrates 24A and 24B. Although not shown in detail, a gate line, an insulating layer, a pixel electrode, and a first alignment layer may be sequentially formed on the lower glass substrate 24A. A black matrix, a color filter, a common electrode, and a second alignment layer may be sequentially formed on the bottom surface of the upper glass substrate 24B. The upper and lower glass substrates 24A and 24B are spaced apart from at a predetermined interval by the ball spacers 26. In other words, the ball spacers 26 maintain the upper and lower glass substrates 24A and 24B at a uniform interval, so that the liquid crystal material 28 may have a uniform thickness.

Although only the liquid crystal display device 400 including the liquid crystal panel 120 bonded to the touch panel 100 according to the first embodiment is shown in FIG. 10, the embodiment is not limited thereto. Accordingly, the present embodiment includes a liquid crystal display device including the liquid crystal panel 120 bonded to the touch panel 200 according to the second embodiment and the touch panel 300 according to the third embodiment.

Any reference in this specification to "one embodiment", "an embodiment", "example embodiment", etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

## Claims

1. A capacitive touch panel (300) comprising:
a substrate (10) having a top surface (111a) and a bottom surface (111b) and including at least one first concave part (101a) on the top surface (111a);
a first transparent electrode (20a) extending in one direction and formed in the first concave part (101a) ;
**characterised in that**:
at least one second concave part (101b) on the bottom surface (111b) of the substrate (10); and a second transparent electrode (20b) extending in a direction crossing the first transparent electrode (20a) and formed in the second concave part (101b),
wherein a sum of a depth of the first concave part (101a) and of the second concave part (101b) corresponds to 50% or less of a thickness of the substrate (10).

2. The capacitive touch panel of claim 1, wherein a protective glass (80) is provided on the top surface (111a).

3. The capacitive touch panel of claim 1, wherein the substrate (10) includes glass.

4. The capacitive touch panel of claim 1, wherein the first and/or second transparent electrodes (20a, 20b) include at least one material selected from the group consisting of a CNT (Carbon nano-tube), conductive polymer, and Ag nano-wire ink.

5. A liquid crystal display device (400) comprising:
a liquid crystal panel (120); and
capacitive touch panel (300) according to any one of claims 1 to 4, provided on a display surface of the liquid crystal panel (400) to receive external information.

6. The liquid crystal display device (400) of claim 5, wherein the liquid crystal panel (120) includes upper and lower glass substrates (24B, 24A), and a liquid crystal material (28) and ball spacers (26) are interposed between the upper and lower glass substrates (24B, 24A).

## Patentansprüche

1. Kapazitives Touchpanel (300), umfassend:
ein Substrat (10), das eine Deckfläche (111a) und eine Grundfläche (111b) aufweist und mindestens einen ersten konkaven Teil (101a) an der Deckfläche (111a) einschließt;
eine erste transparente Elektrode (20a), die sich in einer Richtung erstreckt und im ersten konkaven Teil (101a) gebildet ist;
**gekennzeichnet durch**:
mindestens einen zweiten konkaven Teil (101b) an der Grundfläche (111b) des Substrats (10); und eine zweite transparente Elektrode (20b), die sich in einer die erste transparente Elektrode (20a) kreuzenden Richtung erstreckt und im zweiten konkaven Teil (101b) gebildet ist,
wobei eine Summe aus einer Tiefe des ersten konkaven Teils (101a) und des zweiten konkaven Teils (101b) 50 % oder weniger einer Dicke des Substrats (10) entspricht.

2. Kapazitives Touchpanel nach Anspruch 1, wobei auf der Deckfläche (111a) ein Schutzglas (80) bereitgestellt ist.

3. Kapazitives Touchpanel nach Anspruch 1, wobei das Substrat (10) Glas einschließt.

4. Kapazitives Touchpanel nach Anspruch 1, wobei die erste und/oder zweite transparente Elektrode (20a, 20b) mindestens ein Material einschließen, ausgewählt aus der Gruppe bestehend aus einem CNT (Kohlenstoff-Nanoröhrchen), leitfähigem Polymer, und Ag-Nanodraht-Tinte.

5. Flüssigkristallanzeigevorrichtung (400), umfassend:
ein Flüssigkristallpanel (120); und
das kapazitive Touchpanel (300) nach einem der Ansprüche 1 bis 4, das auf einer Anzeigefläche des Flüssigkristallpanels (400) bereitgestellt ist, um externe Informationen zu empfangen.

6. Flüssigkristallanzeigevorrichtung (400) nach Anspruch 5, wobei das Flüssigkristallpanel (120) obere und untere Glassubstrate (24B, 24A) einschließt, und zwischen dem oberen und unteren Glassubstrat (24B, 24A) ein Flüssigkristallmaterial (28) und Ball-Abstandshalter (26) eingefügt sind.

## Revendications

1. Ecran tactile capacitif (300) comprenant :
un substrat (10) ayant une surface supérieure (111a) et une surface inférieure (111b) et comportant au moins une première partie concave (101a) sur la surface supérieure (111a) ;
une première électrode transparente (20a) s'étendant dans une direction et formée dans la première partie concave (101a) ;
**caractérisé par** :
au moins une seconde partie concave (101b) sur la surface inférieure (111b) du substrat (10) ; et une seconde électrode transparente (20b) s'étendant dans une direction croisant la première électrode transparente (20a) et formée dans la seconde partie concave (101b),
dans lequel une somme d'une profondeur de la première partie concave (101a) et de la seconde partie concave (101b) correspond à 50 % ou moins d'une épaisseur du substrat (10).

2. Ecran tactile capacitif selon la revendication 1, dans lequel un verre protecteur (80) est prévu sur la surface supérieure (111a).

3. Ecran tactile capacitif selon la revendication 1, dans lequel le substrat (10) comporte du verre.

4. Ecran tactile capacitif selon la revendication 1, dans lequel les première et/ou seconde électrodes transparentes (20a, 20b) comportent au moins un matériau choisi dans le groupe constitué d'un CNT (nanotube de carbone), d'un polymère conducteur et d'une encre à nanofils d'Ag.

5. Dispositif d'affichage à cristaux liquides (400) comprenant :
un panneau à cristaux liquides (120) ; et
l'écran tactile capacitif (300) selon l'une quelconque des revendications 1 à 4, prévu sur une surface d'affichage du panneau à cristaux liquides (400) pour recevoir des informations externes.

6. Dispositif d'affichage à cristaux liquides (400) selon la revendication 5, dans lequel le panneau à cristaux liquides (120) comporte des substrats de verre supérieur et inférieur (24B, 24A) et un matériau de cristal liquide (28) et des espaceurs de type bille (26) sont intercalés entre les substrats de verre supérieur et inférieur (24B, 24A).
